# EUROPÄISCHE PATENTSCHRIFT

(11) **EP 0 783 700 B1**
(45) Veröffentlichungstag und Bekanntmachung des Hinweises auf die Patenterteilung: **18.11.1998**
(21) Anmeldenummer: 95934640.4
(22) Anmeldetag: 25.09.1995
(51) Int. Cl.: G01R 15/20

(54) **MESSANORDNUNG ZUR MESSUNG EINES ELEKTRISCHEN STROMES**
DEVICE FOR MEASURING AN ELECTRIC CURRENT
DISPOSITIF POUR LA MESURE D'UN COURANT ELECTRIQUE

(30) Priorität: 26.09.1994 DE 4434417
(43) Veröffentlichungstag der Anmeldung: 16.07.1997
(73) Patentinhaber: Lust Antriebstechnik GmbH, D-35633 Lahnau (DE)
(72) Erfinder: HEBING, Ludger, D-35614 Asslar (DE); KUNZE, Jürgen, D-35585 Wetzlar (DE); LUST, Karl-Heinz, D-35633 Lahnau (DE)
(74) Vertreter: Missling, Arne, Dipl.-Ing.
(86) Internationale Anmeldenummer: EP9503781
(87) Internationale Veröffentlichungsnummer: WO9610186

(56) Entgegenhaltungen:
- DE-A- 4 300 605
- ELEKTRONIK, Bd. 42, Nr. 5, Oktober 1993 MÜNCHEN,DE, Seiten 42-44, XP 000396422 RÜHL ET AL. 'Stromsensor als Mikrosystem'

## Beschreibung

Die Erfindung betrifft eine Anordnung zur Aufnahme eines Stromleiters und zur Messung eines durch den Stromleiter fließenden elektrischen Stromes mit Hilfe einer elektrischen Steuerschaltung mit einem Meßglied in Form einer als Wheatstone-Brücke ausgebildeten Meßbrücke aus magnetoresistiven Meßwiderständen, an die eine elektrische Brückenspannung angelegt ist, und von der zur Messung einer von dem Strom in der unmittelbaren Umgebung des Stromleiters erzeugten magnetischen Feldstärke eine Meßspannung abgegriffen wird, wobei die Meßspannung der Meßbrücke einen Kompensationsstrom im Kompensationsleiter beeinflußt, der so wählbar ist, daß die von dem Meßglied gemessene magnetische Feldstärke kompensiert wird, so daß der Kompensationsstrom proportional dem Strom ist.

Meßanordnungen zur Bestimmung von Magnetfeldern dienen insbesondere zur potentialfreien Messung der Stromstärke eines elektrischen Stromes, der ein derartiges Magnetfeld hervorruft. Da die gesamte Umgebung eines auf diese Weise zu bestimmenden Magnetfeldes stets schon mit großräumigen Störmagnetfeldern behaftet ist, liegt es nahe, mit Hilfe von Magnetfeldgradienten zwischen dem auszumessenden und einem Störmagnetfeld zu unterscheiden.

Eine solche Meßanordnung ist aus der Offenlegungsschrift DE 43 00 605 bereits bekannt, bei der ein mit einer Meßbrücke aus magnetoresistiven Schichtstreifen und einem Dünnschicht-Streifenleiter für einen kompensierenden Steuerstrom ausgestatteter Sensor, mit dem Stromleiter baulich vereint, vorgesehen ist. Hierfür muß der Stromleiter derart angeordnet werden, daß diser U-förmig ausgebildet ist, so daß der Sensor die beiden nebeneinander liegenden Leiterabschnitte übergreift, wobei die magnetfeldempfindlichen Sensorbereiche in einer Ebene liegen. Das erhaltene Ausgangssignal ist störfeldunabhängig, dem auszumessenden Strom proportional und weder temperatur- noch hilfsmagnetfeld-abhängig, wie das von anderen Meßanordnungen her bekannt ist.

Es ist bei diesen Sensoren erforderlich, den Stromleiter zu unterbrechen oder entsprechend verformt anzuordnen, so daß die Meßanordnung in diesem Bereich des Stromleiters vorgesehen ist. Insbesondere bei der Messung größerer Stromstärken ist alleine eine U-förmig gestaltete Stromschiene als Zwischenstück praktikabel, auf der die Meßanordnung bereits angebracht und kalibriert ist, um den Einfluß der geometrischen Abmessungen auf das Übersetzungsverhältnis beherrschen zu können.

Die Erfindung hat sich deshalb die Aufgabe gestellt, diese Nachteile zu beseitigen und eine Meßanordnung der eingangs näher bezeichneten Art so auszubilden, daß sie mit dem unverändert bleibenden Stromleiter zum Messen jederzeit verbunden und bei Bedarf auch ohne weiteres wieder entfernt werden kann, ohne daß die bei derartigen Meßanordnungen bereits realisierbaren Vorteile - potentialfreie, störfeld-, temperatur- und hilfsmagnetfeld-unabhängige Messung - aufgegeben werden müßten.

Erfindungsgemäß wird die Aufgabe dadurch gelöst, daß als Meßglied zwei der elektrischen Brückenspannung ausgesetzte, parallel geschaltete Meßbrücken oder Meßbrückenhälften vorgesehen sind, die aus jeweils vier bzw. zwei in der zugehörigen Meßbrücke oder Meßbrückenhälfte angeordneten magnetoresistiven Meßwiderständen bestehen, die Meßwiderstände in den Meßbrücken oder Meßbrückenhälften in einer gemeinsamen Brückenebene angeordnet und die Widerstände der Meßbrücken oder Meßbrückenhälften in zueinander im wesentlichen flächenparallelen Brückenebenen beiderseits in Bezug auf die Erstreckung des Stromleiters liegen, jede Meßbrücke oder Meßbrückenhälfte eine Kompensationsleitung aufweist, und daß die Summe der Kompensationsströme bzw. der Kompensationsstrom der Meßbrücken oder Meßbrückenhälften gebildet bzw. erfaßt wird, die bzw. der proportional dem fließenden Strom ist.

Die Erfindung macht sich zunutze, daß beiderseits eines Stromleiters das von diesem erzeugte Magnetfeld entgegengerichtet wirkt und in einem (homogenen) Störfeld entweder verstärkt oder geschwächt wird, so daß sich nach wie vor diese störfeldabhängigen Komponenten in der Meßanordnung durch Addition eliminieren. Dabei ist es nun aber auch möglich, daß jeweils eine Meßbrücke zusammen mit der zugehörigen Kompensationsleitung in einem Sensor vereint untergebracht werden kann und daß die beiden Sensoren in einer gemeinsamen Klemmvorrichtung vorgesehen sein können, die als Meßglied über den Stromleiter legbar ist. Eine solche von dem Stromleiter getrennte Ausführung konnte bei der eingangs benannten Meßanordnung mit den Mitteln des Standes bisher nicht angegeben werden.

Es ist besonders vorteilhaft, wenn die Kompensationsleiter an der jeweils zugehörigen Meßbrücke über einen Differenzverstärker angeschlossen sind, an dem andererseits die Meßspannung dieser Mößbrücke anliegt, so daß aus der Summe der Kompensationsströme ein Meßsignal gebildet werden kann, das in geeigneter Weise so verarbeitet wird, daß es der Stromstärke in der Stromleitung proportional ist.

Die Meßbrücken sind entweder über und unter dem Stromleiter vorgesehen, wobei es aus baulichen Gesichtspunkten am besten ist, wenn die Meßbrücken und der Stromleiter waagerecht und jeweils bezüglich einer gemeinsamen senkrechten Symmetrieachse mittig angeordnet sind; dabei kann der Stromleiter waagerecht und parallel zu seiner Längsachse verschoben werden, ohne daß ein nennenswerter Meßfehler auftritt, so lange der Querschnitt des Stromleiters eher breit als hoch ist. Es ist aber auch möglich, daß die Meßbrücken und der Stromleiter nach wie vor waagerecht und die Meßbrücken nun aber rechts und links von der Längsachse des Stromleiters entfernt angeordnet sind, zweckmäßig gleichweit von dem Stromleiter beabstandet; in diesem Fall kann der Stromleiter ebenfalls waagerecht und parallel zu seiner Längsachse, nun aber in großem Umfang verschoben werden, ohne daß ein unzumutbarer Meßfehler aufträte, weil die Meßsignale der Meßbrücken sich zwar wechselweise vermindern und erhöhen, ihre Summe aber (nahezu) unverändert bleibt.

Die erfindungsgemäße Meßanordnung ist gleichermaßen ohne nennenswerte Meßfehler einsetzbar, wenn die Abstände der Längsachse des Stromleiters von den Brückenebenen der Meßbrücken ungleich ist. Die Abweichung kann bis zu 15% differieren, wobei der Meßfehler 5% nicht übersteigt. Vorteilhaft werden die beiden Meßbrücken in einem definierten Abstand angeordnet. Der zwischen diesen befindliche elektrische Leiter kann dann in einem weiten Bereich verschoben werden, ohne daß sich die Summe der beiden Kompensationsströme wesentlich ändert. Hierdurch wird die erforderliche Genauigkeit bei der Montage des Leiters reduziert, d. h. auch Abweichungen von der Soll-Lage beeinflussen das Meßergebnis kaum.

Die Erfindung wird nachstehend an Hand der Zeichnung an einem Ausführungsbeispiel näher erläutert. In dieser zeigen:
- Fig. 1: ein schematisches Schaltbild der erfindungsgemäßen Meßanordnung, teilweise in räumlicher Darstellung und
- Fig. 2: eine Ausführungsform mit nur einer Meßbrücke.

Eine von einem auszumessenden Strom Iₒ durchflossene, als Stromleiter Lᵢ dienende Stromschiene ist Bestandteil eines elektrischen Leistungs-Stromkreises; in der Figur ist ein kurzes, waagerechtes Teilstück einer solchen Stromschiene dargestellt. Die Richtung des Stromes Iₒ ist durch Richtungspfeile P angedeutet.

In der unmittelbaren Umgebung Z über und unter dem Stromleiter Lᵢ und in einer gemeinsamen Symmetrieachse Aₛ sind, zu diesem ortsfest, je eine Meßbrücke Bₒ,Bᵤ in geeigneter Weise angebracht, die aus je vier in der Art einer Wheatstone-Brücke geschalteten magnetoresistiven Meßwiderständen M bestehen und an die eine Brückenspannung U_{b} angelegt ist; dieser Teil der Meßanordnung bildet zusammen mit je einer Kompensationsleitung Lₖ ein Meßglied A.

Die an jeder Meßbrücke Bₒ,Bᵤ abgegriffene Meßspannung Uₘ wird je einem Differnzverstärker V_{d} zugeführt, der den Kompensationsstrom Iₖ in jedem Kompensationsleiter Lₖ derart regelt, daß die Meßspannung Uₘ Null wird.

In jedem Konpensationsleiter Lₖ ist ein Meßwiderstand Rₘ eingeschaltet über den der Spannungsabfall gemessen wird. Diese Spannungen werden einem Operationsverstärker Vₒ zugeführt, der diese addiert. Die Ausgangsspannung Uₛ des Operationsverstärkers Vₒ ist proportional dem zu messenden Strom Iₒ.

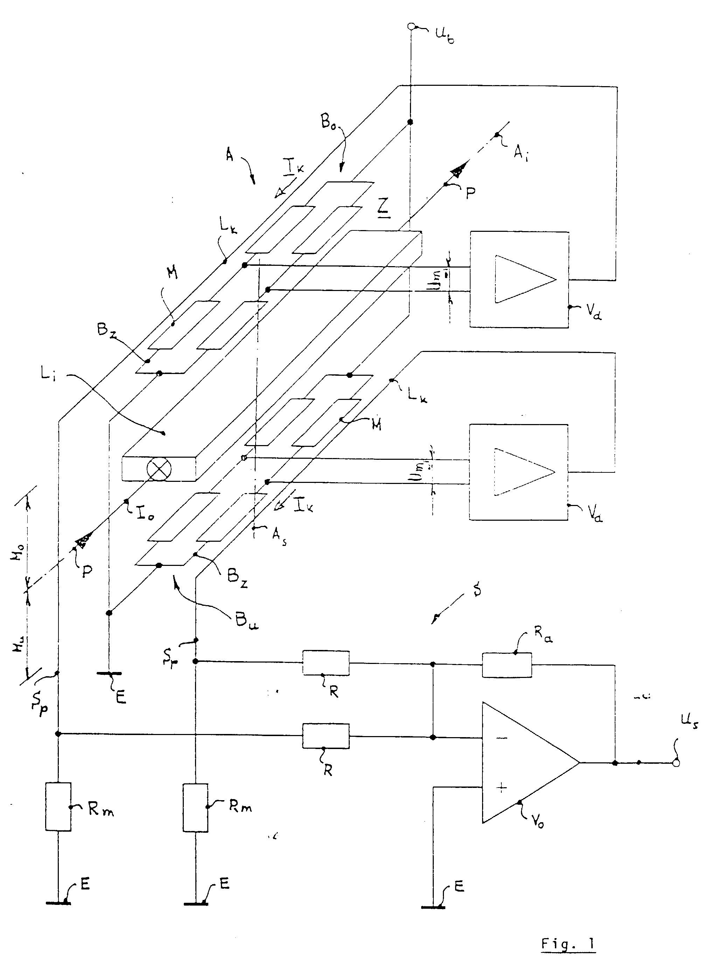

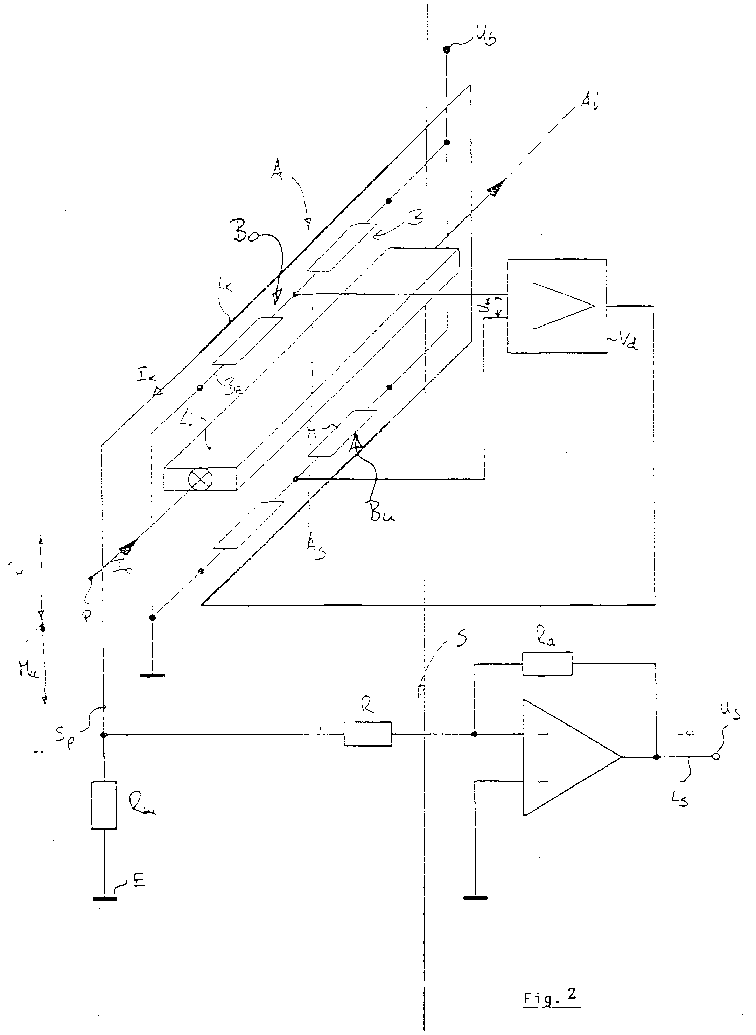

Bei der Ausführungsform nach Fig. 2 besteht der wesentliche Unterschied zu der Anordnung nach Fig. 1 darin, daß nur eine Meßbrücke B anstatt der bisher zwei verwendet wird. Die Brücke ist hier so angeordnet, daß jeweils eine Brückenhälfte auf der Ober- und Unterseite angeordnet wird. Da nur eine Meßbrücke verwendet wird, wird auch nur ein Verstärker V_{d} benötigt; weiterhin entfällt die Addition der beiden Kompensationsströme I_{K}. Die Meßwiderstände in einer Brückenhälfte sind in einer Ebene angeordnet. Die Brückenhälften sind beiderseits des Leiters im wesentlichen flächenparallel angeordnet. Bei dieser Anordnung ist es auch gegeben, daß homogene Störfelder unterdrückt werden und die Anordnung unempfindlich gegenüber ungleichen Abständen der Brückenhälften von dem Stromleiter ist. Der Vorteil dieser Anordnung besteht auch in dem Wegfall eines Differenzverstärkers und der Summationsschaltung. Weiterhin kann der Sensorchip in seiner Baugröße kleiner ausfallen.

Die Anzahl der Meßbrücken oder Meßbrückenhälften kann zur Verstärkung des Signalausganges auch beliebig vervielfacht werden.

### Aufstellung der Bezugszeichen

- A: Meßglied
- Aᵢ: Längsachse
- Aₛ: Symmetrieachse
- B,Bₒ,Bᵤ: Meßbrücke
- B_{z}: Brückenzweig
- E: Nullpotential
- Iₘ: Meßstrom
- Iₒ: Strom
- I_{K}: Kompensationsstrom
- Lᵢ: Stromleiter
- Lₖ: Kompensationsleitung
- Mₒ,Mᵤ: Abstand
- P: Richtungspfeil
- Rₘ: Meßwiderstand
- Rₐ: Abgleich-Widerstand
- S: Steuerschaltung
- Sp: Pfad
- U: Brückenspannung
- Uₘ: Meßspannung
- Uₛ: Ausgangsspannung
- V_{d}: Differenzverstärker
- Vₒ: Operationsverstärker
- Z: Umgebung

## Patentansprüche

1. Anordnung zur Aufnahme eines Stromleiters (Lᵢ) und zur Messung eines durch den Stromleiter fließenden elektrischen Stromes (Iₒ) mit Hilfe einer elektrischen Steuerschaltung (S) mit einem Meßglied (A) in Form einer als Wheatstone-Brücke ausgebildeten Meßbrücke (B) aus magnetoresistiven Meßwiderständen (M), an die eine elektrische Brückenspannung (U_{b}) angelegt ist, und von der zur Messung einer von dem Strom (Iₒ) in der unmittelbaren Umgebung (Z) des Stromleiters (Lᵢ) erzeugten magnetischen Feldstärke eine Meßspannung (Uₘ) abgegriffen wird, wobei die Meßspannung (Uₘ) der Meßbrücke (B) einen Kompensationsstrom (Iₖ) im Kompensationsleiter (Lₖ) beeinflußt, der so wählbar ist, daß die von dem Meßglied (A) gemessene magnetische Feldstärke kompensiert wird, so daß der Kompensationsstrom (Iₖ) proportional dem Strom (Iₒ) ist,
dadurch gekennzeichnet, daß
(a) als Meßglied (A) zwei der elektrischen Brückenspannung (U_{b}) ausgesetzte, parallel geschaltete Meßbrücken oder Meßbrückenhälften (Bₒ,Bᵤ) vorgesehen sind, die aus jeweils vier bzw. zwei in der zugehörigen Meßbrücke oder Meßbrückenhälfte (Bₒ,Bᵤ) angeordneten magnetoresistiven Meßwiderständen (M) bestehen,
(b) die Meßwiderstände (M) in den Meßbrücken oder Meßbrückenhälften (Bₒ,Bᵤ) in einer gemeinsamen Brückenebene angeordnet und
(c) die Widerstände (M) der Meßbrücken oder Meßbrückenhälften (Bₒ,Bᵤ) in zueinander im wesentlichen flächenparallelen Brückenebenen beiderseits in Bezug auf die Erstreckung des Stromleiters (Lᵢ) liegen,
(d) jede Meßbrücke oder Meßbrückenhälfte (Bₒ,Bᵤ) eine Kompensationsleitung (Lₖ) aufweist, und daß die Summe der Kompensationsströme (Ik) bzw. der Kompensationsstrom (Ik) der Meßbrücken oder Meßbrückenhälften (Bᵤ,Bₒ) gebildet bzw. erfaßt wird, die bzw. der proportional dem fließenden Strom (Iₒ) ist.

2. Meßanordnung nach Anspruch 1, dadurch gekennzeichnet, daß in dem Stromkreis jedes Kompensationsleiters (Lₖ) ein Meßwiderstand (Rₘ) eingeschaltet ist, daß der am Meßwiderstand (Rₘ) anliegende Spannungsabfall einem Addierer zugeführt wird, dessen Ausgangssignal (Uₛ) proportional dem Strom (Iₒ) ist.

3. Meßanordnung nach einem der Ansprüche 1 oder 2, dadurch gekennzeichnet, daß die Meßspannung (Uₘ) jeder Meßbrücke oder Meßbrückenhälfte (Bₒ,Bᵤ) einem Differenzverstärker (V_{d}) zugeführt wird, der in Abhängigkeit der Meßspannung (Uₘ) den Strom im Kompensationsleiter (Lₖ) vorgibt.

4. Meßanordnung nach einem der Ansprüche 1 bis 3, dadurch gekennzeichnet, daß die Meßbrücken oder Meßbrückenhälften (Bₒ,Bᵤ) über und unter dem Stromleiter (Lᵢ) bzw. jeweils seitlich des Stromleiters (Lᵢ) vorgesehen sind.

5. Meßanordnung nach Anspruch 4, dadurch gekennzeichnet, daß die Meßbrücken oder Meßbrückenhälften (Bₒ,Bᵤ) und der Stromleiter (Lᵢ) parallel und jeweils bezüglich einer gemeinsamen senkrechten Symmetrieachse (Aₛ) mittig angeordnet sind.

6. Meßanordnung nach Anspruch 4, dadurch gekennzeichnet, daß die Meßbrücken oder Meßbrückenhälften (Bₒ,Bᵤ) und der Stromleiter (Lᵢ) parallel sowie seitlich rechts und links von der Längsachse (Aᵢ₎ des Stromleiters (Lᵢ) versetzt angeordnet sind.

7. Meßanordnung nach einem der Ansprüche 1 bis 6, dadurch gekennzeichnet, daß die Abstände (Mₒ,Mᵤ) der Brückenebenen der Meßbrücken oder Meßbrückenhälften (Bₒ,Bᵤ) voneinander veränderbar sind.

8. Meßanordnung nach einem der Ansprüche 1 bis 7, dadurch gekennzeichnet, daß die Abstände (Mₒ,Mᵤ) von der Längsachse (Aᵢ₎ des Stromleiters (Lᵢ) von den Brückenebenen der Meßbrücken oder Meßbrückenhälften (Bₒ,Bᵤ) gleich sind.

9. Meßanordnung nach einem der Ansprüche 1 bis 8, dadurch gekennzeichnet, daß die Zahl der oben und unten angeordneten Meßbrücken oder Meßbrückenhälften (Bₒ,Bᵤ) vervielfacht wird.

10. Meßanordnung nach einem der Ansprüche 1 bis 9, dadurch gekennzeichnet, daß zusätzlich Meßbrücken oder Meßbrückenhälften (B) an den Seiten des Stromleiters (Lᵢ) angeordnet sind.

11. Meßanordnung nach einem der Ansprüche 1 bis 10, dadurch gekennzeichnet, daß jeweils eine Meßbrücke oder Meßbrückenhälfte (Bₒ,Bᵤ) zusammen mit der zugehörigen Kompensationsleitung (Lₖ) in einem Sensor vereint untergebracht sind und daß die beiden Sensoren in einer gemeinsamen Klemmvorrichtung vorgesehen sind, die als Meßglied (A) über den Stromleiter (Lᵢ) legbar ist.

## Claims

1. An arrangement for receiving an electrical conductor (**L**_{**i**}) and for measuring an electrical current (**I**_{**o**}), flowing through the conductor, with the aid of an electrical control circuit (**S**) with a measuring element (**A**) in the form of a measuring bridge (**B**) designed in the form of a Wheatstone bridge and comprising magnetoresistive measuring resistors (**M**) to which an electrical bridge voltage (**U**_{**b**}) is applied and from which a measurement voltage (**U**_{**m**}) is read off in order to measure a magnetic field strength generated by the current (**I**_{**o**}) in the immediate vicinity (**Z**) of the conductor (**L**_{**i**}), wherein the measurement voltage (**U**_{**m**}) of the measuring bridge (**B**) influences a compensation current (**I**_{**k**}) in the compensation conductor (**L**_{**k**}) which can be selected to be such that the magnetic field strength measured by the measuring element (**A**) is compensated, so that the compensation current (**I**_{**k**}) is proportional to the current (**I**_{**o**}),
**characterized in that**
(a) the measuring element (**A**) is provided in the form of two measuring bridges or measuring-bridge halves (**B**_{**o**}**, B**_{**u**}) which are subjected to the electrical bridge voltage (**U**_{**b**}) and are connected in parallel and which each comprise four or two magnetoresistive measuring resistors (**M**) arranged in the associated measuring bridge or measuring-bridge half (**B**_{**o**}, **B**_{**u**}) respectively,
(b) the measuring resistors (**M**) in the measuring bridges or measuring-bridge halves (**B**_{**o**}, **B**_{**u**}) are arranged in a common bridge plane,
(c) the resistors (**M**) in the measuring bridges or measuring-bridge halves (**B**_{**o**}, **B**_{**u**}) are situated in essentially mutually parallel bridge planes on both sides with respect to the extension of the conductor (**L**_{**i**}),
(d) each measuring bridge or measuring-bridge half (**B**_{**o**}, **B**_{**u**}) has a compensation line (**L**_{**k**}), and the sum of the compensation currents (**I**_{**k**}) or the compensation current (**I**_{**k**}) of the measuring bridges or measuring-bridge halves (**B**_{**u**}**, B**_{**o**}), which is or are proportional to the flowing current (**I**_{**o**}), is formed and detected respectively.

2. A measuring arrangement according to Claim 1, **characterized in that** a measuring resistor (**R**_{**m**}) is connected in the circuit of each compensation conductor (**L**_{**k**}), [and] the drop in voltage occurring at the measuring resistor (**R**_{**m**}) is fed to an adder, the output signal (**U**_{**s**}) of which is proportional to the current (**I**_{**o**}).

3. A measuring arrangement according to one of Claims 1 and 2, **characterized in that** the measurement voltage (**U**_{**m**}) of each measuring bridge or measuring-bridge half (**B**_{**o**}**, B**_{**u**}) is fed to a differential amplifier (**V**_{**d**}) which pre-sets the current in the compensation line (**L**_{**k**}) as a function of the measurement voltage (**U**_{**m**}).

4. A measuring arrangement according to one of Claims 1 to 3, **characterized in that** the measuring bridges or measuring-bridge halves (**B**_{**o**}, **B**_{**u**}) are provided above and below the conductor (**L**_{**i**}) or at the side of the conductor (**L**_{**i**}) respectively.

5. A measuring arrangement according to Claim 4, **characterized in that** the measuring bridges or measuring-bridge halves (**B**_{**o**}, **B**_{**u**}) and the conductor (**L**_{**i**}) are arranged parallel and centrally in each case with respect to a common vertical axis of symmetry (**A**_{**s**}).

6. A measuring arrangement according to Claim 4, **characterized in that** the measuring bridges or measuring-bridge halves (**B**_{**o**}, **B**_{**u**}) and the conductor (**L**_{**i**}) are arranged parallel and laterally offset to the right and left from the longitudinal axis (**A**_{**i**}) of the conductor (**L**_{**i**}).

7. A measuring arrangement according to one of Claims 1 to 6, **characterized in that** the distances (**M**_{**o**}, **M**_{**u**}) of the bridge planes of the measuring bridges or measuring-bridge halves (**B**_{**o**}, **B**_{**u**}) from one another are variable.

8. A measuring arrangement according to one of Claims I to 7, **characterized in that** the distances (**M**_{**o**}, **M**_{**u**}) of the longitudinal axis (**A**_{**i**}) of the conductor (**L**_{**i**}) from the bridge planes of the measuring bridges or measuring-bridge halves (**B**_{**o**}, **B**_{**u**}) are equal.

9. A measuring arrangement according to one of Claims 1 to 8, **characterized in that** the number of the measuring bridges or measuring-bridge halves (**B**_{**o**}, **B**_{**u**}) arranged above and below is multiplied.

10. A measuring arrangement according to one of Claims 1 to 9, characterized in that measuring bridges or measuring-bridge halves (**B**) are additionally arranged at the sides of the conductor (**L**_{**i**}).

11. A measuring arrangement according to one of Claims 1 to 10, **characterized in that** one respective measuring bridge or measuring-bridge half (**B**_{**o**}, **B**_{**u**}) together with the associated compensation line (**L**_{**k**}) is housed in a combined manner in a sensor in each case, and the two sensors are provided in a common clamping device which can be positioned as the measuring element (**A**) above the conductor (**L**_{**i**}).

## Revendications

1. Dispositif pour recevoir un conducteur de courant (Lᵢ) et pour mesurer un courant électrique (Iₒ) s'écoulant par ce conducteur de courant en utilisant un circuit électrique de commande (S) comportant un organe de mesure (A), constitué d'un pont de mesure (B) réalisé sous la forme d'un pont de Wheatstone, composé de résistances de mesure à effet magnétorésistif (M), sur lequel est appliquée une tension électrique de pont (U_{b}), et par lequel, pour mesurer l'intensité d'un champ magnétique produit par le courant (Iₒ) dans l'environnement direct (Z) du conducteur de courant (Lᵢ), une tension de mesure (Uₘ) est relevée, la tension de mesure (Uₘ) du pont de mesure (B) agissant sur un courant de compensation (Iₖ), qui passe dans le conducteur de compensation (Lₖ) et qui peut être choisi pour que l'intensité du champ magnétique mesurée par l'organe de mesure (A) soit compensée de façon que le courant de compensation (Iₖ) soit proportionnel au courant (Iₒ),
caractérisé en ce que
(a) comme organe de mesure (A), sont prévus deux ponts de mesure ou demi-ponts de mesure (Bₒ, Bᵤ) branchés en parallèle et soumis à la tension électrique de pont (U_{b}), constitués respectivement chacun de quatre ou deux résistances de mesure à effet magnétorésistif (M) disposées dans les ponts de mesure ou demi-ponts de mesure (Bₒ, Bᵤ) correspondants,
(b) les résistances de mesure (M) situées dans les ponts de mesure ou demi-ponts de mesure (Bₒ, Bᵤ) sont disposées dans un plan commun des ponts,
(c) les résistances de mesure (M) des ponts de mesure ou demi-ponts de mesure (Bₒ, Bᵤ) sont situés dans des plans des ponts, sensiblement parallèles et situées de part et d'autre de l'emplacement du conducteur de courant (Lᵢ),
(d) chacun des ponts de mesure ou demi-ponts de mesure (Bₒ, Bᵤ) comporte un conducteur de compensation (Lₖ), et en ce que respectivement on forme la somme des courants de compensation (Iₖ) ou on relève le courant de compensation (Iₖ) des ponts de mesure ou demi-ponts de mesure (Bᵤ**,** Bₒ), ce courant ou ces courants étant respectivement proportionnels au courant traversant (Iₒ).

2. Dispositif de mesure suivant la revendication 1, caractérisé en ce que, dans le circuit de courant de chaque conducteur de compensation (Lₖ), est branchée une résistance de mesure (Rₘ) et en ce que la chute de tension présente aux bornes de la résistance de mesure (Rₘ) est envoyée à un additionneur, dont le signal de sortie (Uₛ) est proportionnel au courant (Iₒ).

3. Dispositif de mesure suivant la revendication 1 ou 2, caractérisé en ce que la tension de mesure (Uₘ) de chaque pont de mesure ou de chaque demi-pont de mesure (Bₒ, Bᵤ) est envoyée à un amplificateur différenciel (Vd) qui, en fonction de la tension de mesure (Uₘ), détermine le courant dans le conducteur de compensation (Lₖ).

4. Dispositif de mesure suivant l'une des revendications 1 à 3, caractérisé en ce que les ponts de mesure ou demi-ponts de mesure (Bₒ, Bᵤ) sont prévus au-dessus et au-dessous du conducteur de courant (Lᵢ), ou respectivement de part et d'autre du conducteur de courant (Lᵢ).

5. Dispositif de mesure suivant la revendication 4, caractérisé en ce que les ponts de mesure ou demi-ponts de mesure (Bₒ, Bᵤ) et le conducteur de courant (Lᵢ) sont disposés parallèlement et respectivement symétriquement par rapport à un axe de symétrie (Aₛ) vertical commun.

6. Dispositif de mesure suivant la revendication 4, caractérisé en ce que les ponts de mesure ou demi-ponts de mesure (Bₒ, Bᵤ) et le conducteur de courant (Lᵢ) sont disposés parallèlement et, en même temps, décalés latéralement à droite et à gauche de l'axe longitudinal (Aᵢ) du conducteur de courant (Lᵢ).

7. Dispositif de mesure suivant l'une des revendications 1 à 6, caractérisé en ce que les distances (Mₒ, Mᵤ) séparant les plans des ponts de mesure ou demi-ponts de mesure (Bₒ, Bᵤ) peuvent être modifiées.

8. Dispositif de mesure suivant l'une des revendications 1 à 7, caractérisé en ce que les distances (Mₒ, Mᵤ) séparant l'axe longitudinal (Aᵢ) du conducteur de courant (Lᵢ) des plans des ponts de mesure ou demi-ponts de mesure (Bₒ, Bᵤ) sont égales.

9. Dispositif de mesure suivant l'une des revendications 1 à 8, caractérisé en ce que le nombre des ponts de mesure ou demi-ponts de mesure (Bₒ, Bᵤ) disposés au-dessus et au-dessous est multiplié.

10. Dispositif de mesure suivant l'une des revendications 1 à 9, caractérisé en ce que des ponts de mesure ou demi-ponts de mesure (B) sont disposés sur les côtés du conducteur de courant (Lᵢ).

11. Dispositif de mesure suivant l'une des revendications 1 à 10, caractérisé en ce que chaque pont de mesure ou un demi-pont de mesure (Bₒ, Bᵤ) est logé dans un détecteur conjointement avec le conducteur de compensation (Lₖ) associé, et en ce que les deux détecteurs sont prévus dans un dispositif de fixation par pincement commun, qui peut être placé, comme organe de mesure (A), au-dessus du conducteur de courant (Lᵢ).
